# DEMANDE DE BREVET EUROPEEN

(11) **EP 0 567 371 A1**
(43) Date de publication de la demande: **27.10.1993**
(21) Numéro de dépôt: 93400971.3
(22) Date de dépôt: 14.04.1993
(51) Int. Cl.: H05K 9/00

(54) **Système d'assemblage de panneaux blindés constituant une cage de Faraday**

(30) Priorité: 22.04.1992 FR 9204932
(71) Demandeur: SIEPEL - Société Industrielle d'Etudes et Protection Electronique, F-56470 La Trinité-sur-Mer (FR)
(72) Inventeur: Ruelle, Philippe, F-56400 Pluneret (FR); Le Baron, Philippe, F-56470 La Trinite-sur-Mer (FR)
(74) Mandataire: Jaunez, Xavier

(57) **Abrégé**

L'invention concerne un système d'assemblage de panneaux blindés constituant une cage de Faraday, comportant un profilé (100) contre lequel deux panneaux adjacents (P) sont maintenus en appui.

Conformément à l'invention, le profilé (100) a en section la forme générale d'un oméga, avec une portion latérale (101) et deux ailes latérales (102) définissant deux dièdres servant chacun à recevoir un bord de panneau (204), chacun de ces dièdres de réception définissant un angle notablement inférieur à 90° de façon à obtenir un report de la zone de contact à distance de l'arête (205) du bord de panneau correspondant.

## Description

L'invention concerne l'assemblage de panneaux, et plus particulièrement l'assemblage de panneaux blindés constituant une cage de Faraday, au moyen de systèmes d'assemblage comportant un profilé contre lequel deux panneaux adjacents sont maintenus en appui.

On connaît un système d'assemblage de panneaux blindés constituant une cage de Faraday, utilisant des profilés dont la section se présente sous la forme d'un U complété par deux ailes latérales qui s'étendent perpendiculairement aux branches latérales parallèles du U, comme illustré dans le document US-A-3 745 226.

Lorsqu'un panneau blindé est positionné pour son assemblage, il est appliqué par le rebord d'une face contre une aile latérale du profilé, et sa facette de chant est amenée en appui contre la branche latérale de ce profilé, et il en va de même pour le panneau adjacent.

La zone de contact concerne ainsi, pour chaque panneau blindé, l'arête du bord du panneau et les parties de surface directement adjacentes de ce panneau.

Lorsque l'on souhaite assembler des panneaux composites, comportant une feuille ou une plaque collée sur l'une et/ou l'autre de ses deux faces, il est bien connu que le positionnement obtenu risque d'être imparfait si on est en présence de bavures au voisinage de l'arête concernée, ce qui est précisément le cas lorsque les panneaux concernés sont assemblés pour constituer une cage de Faraday, les panneaux étant alors blindés, par exemple en collant une feuille de blindage sur un panneau en bois (en général en contre-plaqué).

Or on sait que la propriété principale d'une cage de Faraday est de former une barrière isolante aux ondes électromagnétiques entre l'intérieur et l'extérieur de la cage de Faraday (ceci par exemple pour éviter qu'un signal électromagnétique émis à l'intérieur de la cage de Faraday puisse être capté à l'extérieur, ou inversement pour protéger l'intérieur de la cage contre une influence électromagnétique extérieure).

De ce fait, un assemblage imparfait d'un ou plusieurs panneaux altère automatiquement l'étanchéité électromagnétique.

De plus, avec les panneaux blindés constituant une cage de Faraday, on cherche à préserver autant que faire se peut la continuité électrique entre les deux panneaux adjacents qui sont appliqués contre un profilé métallique commun. Or, la qualité de ce contact risque précisément d'être altérée par suite d'un positionnement imparfait.

Enfin, dans le cas de cages de Faraday de volume intérieur important, on cherche souvent à rigidifier au moins la face supérieure de la cage, au moyen de profilés de raidissement disposés transversalement, ces derniers profilés étant reliés aux profilés d'assemblage par des vis dont le diamètre de filet est légèrement supérieur à la distance séparant les deux branches parallèles des profilés d'assemblage, de façon à être rentrées par vissage en force. On pourrait naturellement percer les profilés d'assemblage pour passer des tirants de liaison, ce qui améliorerait largement la tenue mécanique, mais ces perçages risqueraient de ruiner la qualité de l'étanchéité électromagnétique.

Une autre solution, illustrée dans le document EP-A-0 262 794 peut également être citée, visant à obtenir simultanément un support mécanique et un contact électrique satisfaisants, en utilisant un insert rigide disposé dans un profilé en U à parois minces dont les ailes sont disposées contre le blindage extérieur des panneaux avec un contact sur toute leur surface.

L'invention a précisément pour but de résoudre ce problème, en concevant un profilé dont l'agencement permet d'éviter les inconvénients et/ou limitations précités.

L'état de la technique est par ailleurs illustré par les systèmes d'assemblage étanche de panneaux de façade. C'est ainsi que le document FR-A-2 461 069 décrit l'utilisation d'un profilé en oméga dont les ailes droites sont repliées à leur bord libre pourformer des bords d'accrochage pour un joint d'étanchéité. Le document US-A-4 192 113 décrit l'utilisation d'un profilé d'angle dont les ailes d'appui sont initialement inclinées de façon à contacter par toute leur surface les panneaux concernés lorsque le serrage a été réalisé (voir les figures 8A et 8B de ce document). Cet enseignement général va donc à l'encontre de la recherche d'une zone de contact localisée, ce qui est normal dans la mesure où le problème à résoudre est celui de l'étanchéité à l'eau.

L'invention a ainsi pour objet de réaliser un système d'assemblage de panneaux blindés permettant d'avoir un positionnement très précis des panneaux assemblés, que ces panneaux soient disposés dans le prolongement l'un de l'autre ou perpendiculairement l'un à l'autre, et procurant une ligne de contact bien définie sur la face de chaque panneau blindé, ce qui est particulièrement important pour la réalisation de cages de Faraday, et a fortiori dans le cas de cages de Faraday de dimensions importantes (par exemple avec des panneaux blindés dont la longueur peut atteindre cinq mètres).

Il s'agit plus particulièrement d'un système d'assemblage de panneaux blindés constituant une cage de Faraday, comportant un profilé contre lequel deux panneaux adjacents sont maintenus en appui, caractérisé par le fait que le profilé a en section, la forme générale d'un oméga, avec une portion centrale et deux ailes latérales définissant deux dièdres servant chacun à recevoir un bord de panneau, chacun de ces dièdres de réception définissant un angle notablement inférieur à 90° de façon à obtenir un report de la zone de contact à distance de l'arête du bord de panneau correspondant.

De préférence, la zone de contact est, pour chaque bord de panneau, reportée d'une part pourla face concernée au niveau d'une arête d'extrémité de l'aile latérale correspondante, et d'autre part pour la facette de chant concernée au niveau du bord correspondant de la portion centrale, sensiblement à mi-épaisseur du panneau.

On parvient ainsi à contourner parfaitement l'arête du bord de panneau, et à reporter les contacts au niveau de deux lignes qui s'étendent à une distance suffisante de cette arête.

Conformément à un mode d'exécution particulier, le profilé admet un plan longitudinal de symétrie, et est agencé pour assembler deux panneaux adjacents qui sont dans le prolongement l'un de l'autre, avec une portion centrale dont les branches latérales convergent vers le plan de symétrie, et deux ailes latérales légèrement inclinées vers cette portion centrale en s'éloignant d'un plan tangent commun perpendiculaire audit plan de symétrie.

Avantageusement alors, la portion centrale a un profil en forme de U resserré, dont les angles intérieurs sont compris entre 75° et 85°, en étant de préférence voisins de 80°. Il est également intéressant que chaque aile latérale forme un angle prédéterminé avec le plan tangent commun, cet angle étant compris entre 1 ° et 5°, en étant de préférence voisin de 2°.

Conformément à un autre mode d'exécution, le profilé admet un plan longitudinal de symétrie, et est agencé pour assembler deux panneaux adjacents qui sont essentiellement perpendiculaires entre eux, avec une portion centrale dont les branches latérales s'écartent du plan de symétrie, et deux ailes latérales légèrement inclinées vers cette portion centrale en s'éloignant d'un plan tangent commun perpendiculaire audit plan de symétrie.

De préférence alors, la portion centrale a un profil en forme de U divergent, dont les angles intérieurs sont compris entre 120° et 130°, en étant de préférence voisins de 125°. Il est également intéressant que chaque aile latérale forme un angle prédéterminé avec le plan tangent commun, cet angle étant compris entre 46° et 50°, en étant de préférence voisin de 47°.

Selon une autre caractéristique particulière, les profilés contre lesquels s'appuient des panneaux horizontaux constituant le toit de la cage de Faraday, reçoivent à l'intérieur de leur portion centrale et au niveau de leurs extrémités, un insert de jonction permettant l'accrochage d'un profilé de bord perpendiculaire à ces profilés, agencé pour assembler les panneaux horizontaux à des panneaux verticaux adjacents.

Avantageusement alors, l'insert de jonction comporte deux portions rigidement liées entre elles, dont une portion prismatique à section trapézoïdale correspondant à celle de la portion centrale du profilé concerné, et une portion en forme de barreau s'étendant transversalement à la portion prismatique, ladite portion prismatique présentant en outre un béquet s'étendant à distance du barreau pour définir une fente de réception associée à l'aile latérale correspondante du profilé de bord.

D'autres caractéristiques et avantages de l'invention apparaîtront plus clairement à la lumière de la description qui va suivre et du dessin annexé, concernant un mode de réalisation particulier, en référence aux figures où :
- la figure 1 illustre en perspective le profilé d'assemblage d'un système conforme à l'invention ;
- la figure 2 est une coupe selon II-II de la figure 1, permettant de mieux distinguer le profil particulier de la section du profilé d'assemblage ;
- la figure 3 illustre en coupe l'assemblage de deux panneaux blindés au moyen d'un système conforme à l'invention, ces panneaux étant en l'espèce disposés dans le prolongement l'un de l'autre, le profilé d'assemblage étant en outre complété par un profilé de serrage assurant le maintien des bords des panneaux concernés ;
- la figure 4 illustre en coupe un autre type d'assemblage au moyen d'une variante du système selon l'invention, les panneaux blindés étant alors perpendiculaires entre eux ;
- la figure 5 complète la vue de la figure 3, en montrant un insert de jonction logé en extrémité d'un profilé d'assemblage, pour faciliter la mise en place d'un profilé de bord du type de celui illustré en figure 4, tout en participant à la tenue mécanique de l'assemblage réalisé ;
- la figure 6 est une coupe selon VI-VI de la figure 5 (à rapprocher de la figure 4) permettant de mieux distinguer le positionnement de l'insert de jonction (la figure 5 est alors une coupe selon V-V de la figure 6) ;
- les figures 7 à 9 sont des vues en élévation de la pièce de jonction précitée.

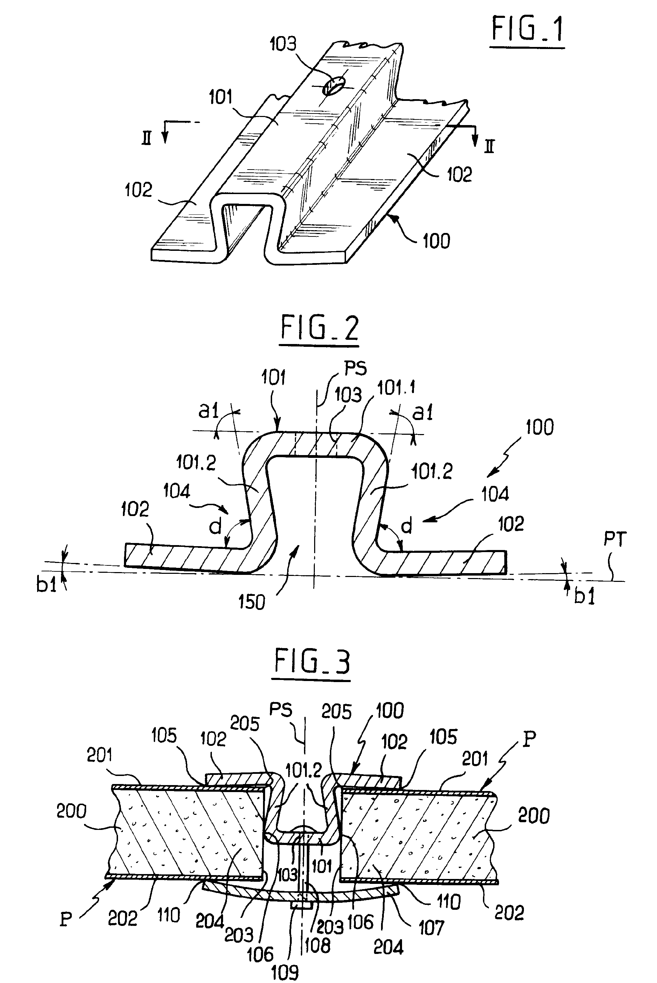

La figure 1 illustre en perspective un profilé d'assemblage 100 constituant l'élément essentiel du système d'assemblage de panneaux blindés constituant une cage de Faraday, conformément à une caractéristique de l'invention. Le profilé 100 a en section la forme générale d'un oméga, avec une portion centrale 101 et deux ailes latérales 102. La portion centrale 101 présente des perçages traversants 103 pour le raccordement du profilé d'assemblage 100 à un profilé de serrage qui sera ultérieurement décrit en référence à la figure 3.

Il convient de se référer à la figure 2 pour mieux apprécier le profil particulier de la section du profilé d'assemblage 100 précité. La portion centrale 101 du profilé 100 comporte une branche centrale 101.1 et deux branches latérales 101.2 qui convergent vers un plan longitudinal de symétrie PS. A ces branches latérales 101.2 se raccordent les deux ailes latérales 102 du profilé d'assemblage 100, de préférence, par des congés arrondis provenant du pliage effectué pour obtenir ce profilé, par exemple au moyen d'une machine à galet. Chaque branche latérale 101.2 définit avec l'aile latérale 102 adjacente un dièdre de réception 104 servant à recevoir un bord de panneau.

Conformément à un aspect essentiel de l'invention, chacun des dièdre de réception définit un angle d notablement inférieur à 90°, de façon à obtenir un report de la zone de contact à distance de l'arête du bord du panneau blindé correspondant. En réalité, l'angle d précité résulte du pliage de la branche latérale 101.2 par rapport à la branche centrale 101.1, définissant un premier angle a1, puis du pliage de l'aile latérale 102 par rapport à la branche latérale 101.2, définissant un deuxième angle b1 par rapport à un plan tangent commun PT qui est perpendiculaire au plan de symétrie PS du profilé. Ainsi, les branches latérales 101.2 convergent vers le plan de symétrie PS (angle a1), et les deux ailes latérales 102 sont légèrement inclinées vers cette portion centrale, en s'éloignant du plan tangent commun PT (angle b1).

Cette conformation particulière que présente la section du profilé d'assemblage 100 permet d'obtenir un report de la zone de contact à distance de l'arête de chacun des bords de panneau concernés. En effet, si l'on se réfère à la figure 3, on retrouve le profilé d'assemblage 100 précité, contre lequel sont appliqués deux panneaux blindés P, ici disposés dans le prolongement l'un de l'autre. Chaque panneau P comporte une portion centrale 200 qui est par exemple en bois, telle que du contre-plaqué, et deux faces 201, 202 formant le blindage métallique extérieur du panneau. Chacun des panneaux P présente une facette de chant 203 qui est en appui contre le bord de la portion centrale 101 du profilé d'assemblage 100, ici selon une ligne de contact 106 qui est à mi-épaisseur du panneau P concerné. Le contact avec la face 201 de chacun des panneaux P est reporté au niveau d'une arête d'extrémité 105 de l'aile latérale 102 correspondante du profilé d'assemblage 100.

Ainsi, on constate que le profilé d'assemblage 100 n'est au contact de chaque panneau blindé qu'au niveau de son arête 105 sur la face métallique 201, et à mi-épaisseur du panneau sur la ligne 106 : ceci signifie que l'on est parvenu à contourner parfaitement l'arête correspondante 205 du bord de panneau 204, de sorte que l'on s'affranchit de toute éventuelle bavure ou aspérité susceptible de se trouver au niveau de cette arête, ce qui assure ainsi un parfait positionnement de chacun des panneaux blindés en appui contre le profilé d'assemblage 100. De plus, le contact selon l'arête 105 sur la face de blindage 201 est parfaitement localisé, ce qui est extrêmement favorable sur le plan de la continuité électrique entre les deux panneaux blindés adjacents. Il est à noter que ce contact ponctuel est d'autant meilleur que le profilé d'assemblage 100 est appliqué plus fermement contre les faces de blindage 201 des panneaux concernés, ce qui est aisément obtenu au moyen des organes de serrage qui vont être décrits ci-après.

Pour maintenir les deux bords de panneau 204 contre le profilé d'assemblage 100 précédemment décrit, il est prévu de manière connue dans ce domaine, un profilé de serrage 107, qui est de préférence légèrement cintré pour contacter au niveau de ses arêtes 110 les faces de blindages 202 des deux panneaux concernés. Les profilés 100 et 107 sont réunis entre eux au moyen de vis ou de boulons de liaison 108, passant par les perçages associés 103 ménagés à cette effet dans la portion centrale 101 du profilé d'assemblage 100, le serrage désiré étant obtenu au moyen d'un écrou 109 ou de tout organe équivalent. Ainsi, une fois les deux panneaux P disposés en appui par leurs facettes de chant 203 de chaque côté de la portion centrale du profilé d'assemblage 100, il suffit de procéder au serrage du profilé 107, afin d'assurer le maintien des deux panneaux alors parfaitement positionnés.

La portion centrale 101 présente en l'espèce un profil en forme de U resserré, dont les angles inférieurs a1 sont de préférence compris entre 75° et 85°, avec une valeur préférentielle voisine de 80°. Chaque aile latérale 102 forme quant à elle un angle prédéterminé b1 avec le plan tangent PT, cette angle étant compris entre 1° et 5°, avec une valeur préférée voisine de 2°. Les fourchettes données pour les angles a1 et b1 précités définissent ainsi l'angle d d'ouverture du dièdre de réception servant à recevoir chaque bord de panneau, lequel doit en tout état de cause être notablement inférieur à 90°.

Etant donné qu'il s'agit de panneaux blindés constituant une cage de Faraday, le profilé d'assemblage 100 contacte de préférence les faces de blindage 201 qui sont à l'extérieur de la cage de Faraday, les faces de blindage intérieures 202 étant quant à elles contactées par le profilé de serrage 107, conformément à un agencement connu. Lorsqu'il s'agit de réaliser la face supérieure de la cage de Faraday, il peut s'avérer intéressant de rigidifier cette face au moyen de profilés de raidissement disposés transversalement aux profilés d'assemblage 100. Avec la disposition particulière du présent profilé d'assemblage, l'espace intérieur 150 de la portion centrale 101 de ce profilé permet l'insertion d'un taquet maintenu dans la gorge en queue d'aronde naturellement obtenue. On peut ainsi utiliser des taquets à pans inclinés pour les liaisons à des rails raidisseurs transversaux, ce qui évite d'avoir à utiliser un vissage en force comme c'était le cas pour les systèmes d'assemblage connus.

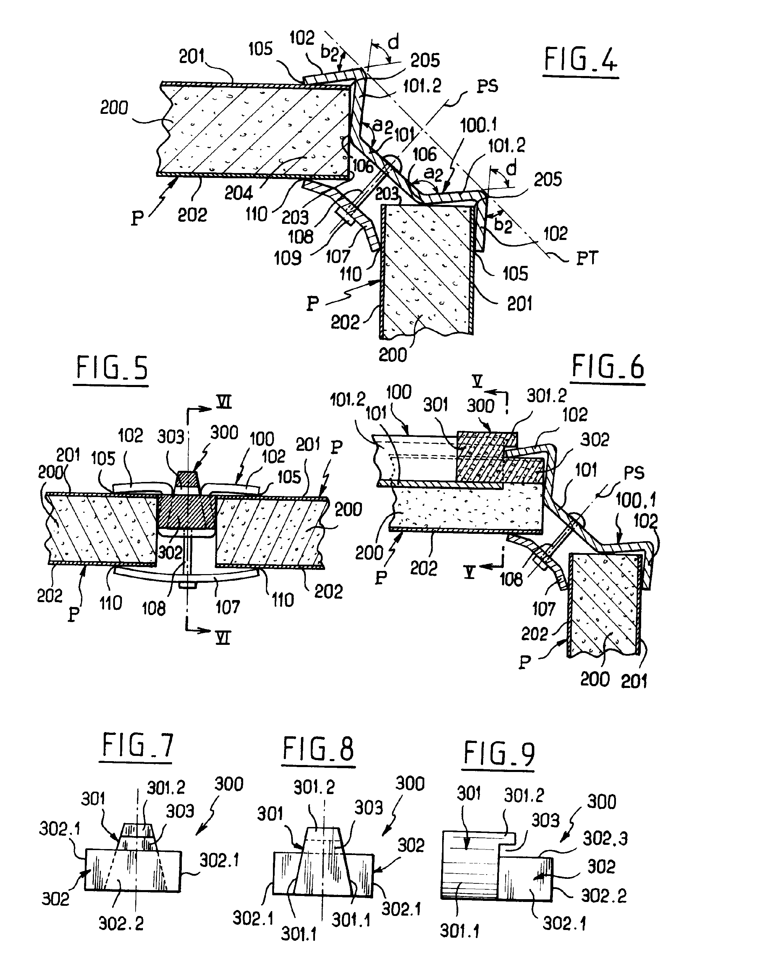

L'invention permet également d'organiser l'assemblage de panneaux blindés adjacents qui sont essentiellement perpendiculaires entre eux, ainsi que cela a été illustré sur la figure 4.

Le profilé d'assemblage 100.1 admet un plan longitudinal de symétrie PS, et est agencé pour assembler deux panneaux adjacents P qui sont essentiellement perpendiculaires entre eux, ce profilé comportant comme précédemment une portion centrale 100.1, mais dont les branches latérales 101.2 s'écartent du plan de symétrie PS, ainsi que deux ailes latérales 102 qui sont légèrement inclinées vers cette portion centrale en s'éloignant d'un plan tangent commun PT perpendiculaire au plan de symétrie PS. Ainsi, dans ce cas, la forme générale en oméga est plus ouverte que dans le cas de l'assemblage de deux profilés disposés dans le prolongement l'un de l'autre. On retrouve cependant les deux dièdres de réception définis par les branches latérales 101.2 et les ailes latérales 102 associées, chacun de ces dièdres de réception définissant un angle d notablement inférieur à 90° de façon à obtenir un report de la zone de contact à distance de l'arête 205 de chacun des bords de panneau 204 correspondant. Ainsi, comme précédemment, on retrouve, pour chaque bord de panneau 204, un zone de contact qui est reportée, d'une part pour la face concernée au niveau d'une arête d'extrémité 105 de l'aile latérale 102 correspondante, et d'autre part pour la facette de chant concernée 203 au niveau du bord correspondant 106 de la portion centrale 101 du profilé 101.1, sensiblement à mi-épaisseur du panneau blindé P concerné.

La modification de la section du profilé d'assemblage 100.1 réside ainsi essentiellement dans le choix différent des angles de pliage précédemment notés a1 et b1. En effet, la portion 101 du profilé d'assemblage 100.1 a ici un profil en forme de U divergent, dont les angles intérieurs a2 sont avantageusement compris entre 120° et 130°, avec une valeur préférée voisine de 125°. De plus, chaque aile latérale 102 forme un angle prédéterminé b2 avec le plan tangent commun PT, cette angle étant avantageusement compris entre 46° et 50° en étant de préférence voisin de 47°.

On retrouve par ailleurs un profilé de serrage 107 analogue, contactant au niveau de ses arêtes 110 une face de blindage 202, ledit profilé étant relié au profilé d'assemblage 100.1 par des moyens analogues à ceux précédemment décrits.

De tels profilés de bord 100.1 sont de préférence utilisés au niveau des arêtes verticales de la cage de Faraday, les faces de blindage 202 étant dans ce cas tournées du côté intérieur de la cage (la figure 4 est alors dans ce cas une coupe par un plan horizontal). De tels profilés de bord 100.1 peuvent également être utilisés pour le raccordement de panneaux horizontaux et de panneaux verticaux (la figure 4 étant alors une coupe par un plan vertical). Il convient alors dans ce cas d'organiser le raccordement des différents profilés d'assemblage qui sont utilisés pour les panneaux constituant la face horizontale, ces profilés arrivant perpendiculairement sur un profilé de bord 101.1, au niveau d'une arête horizontale de la cage de Faraday.

Un tel type d'assemblage a été illustré à titre d'exemple aux figures 5 et 6.

Ainsi, conformément à une autre caractéristique de l'invention, les profilés 100 contre lesquels s'appuient des panneaux blindés horizontaux reçoivent à l'intérieur de leur portion centrale 101, au niveau leurs extrémités, un insert de jonction 300 permettant l'accrochage d'un profilé de bord 100.1 perpendiculaire à ces profilés 100, agencé pour rassembler des panneaux horizontaux à des panneaux verticaux adjacents.

Les figures 7 à 9 permettant de mieux appréhender la structure particulière de l'insert de jonction 300 utilisé pour un tel raccordement. L'insert 300 comporte ainsi deux portions 301, 302 rigidement liées entre elles, dont une portion prismatique 301 et une portion en forme de barreau 302. La portion prismatique 301 est à section trapézoïdale, avec des facettes inclinées 301.1 qui sont homologues aux branches latérales de la portion centrale du profilé d'assemblage. La portion 302 en forme de barreau s'étend quant à elle transversalement à la portion prismatique 301, et cette portion prismatique 301 présente en outre un béquet 301.2 s'étendant à distance du barreau 302, au dessus de la facette supérieure 302.3 de celui-ci, pour définir une fente de réception 303 associée à l'aile latérale 102 du profilé de bord 100.1. On a noté 302.1 les faces latérales de la portion 302 en forme de barreau, et 302.2 la face frontale de ladite portion.

Si l'on revient maintenant aux figures 5 et 6, on comprend que l'insert de jonction 300 est inséré en extrémité du profilé d'assemblage 100 concerné par sa portion prismatique 301, ladite portion faisant ainsi fonction de taquet reçu dans une rainure en queue d'aronde. La portion en forme de barreau complète alors l'intervalle séparant deux panneaux horizontaux adjacents, de sorte que l'aile latérale 102, qui est en appui sur les faces de blindage 201 de ces panneaux, est pincée dans la fente de réception 303, le becquet 301.2 assurant ainsi la reprise des efforts correspondants.

On est ainsi parvenu à réaliser un système d'assemblage de panneaux blindés permettant d'avoir un positionnement très précis des panneaux assemblés, que ces panneaux soient disposés dans le prolongement l'un de l'autre ou perpendiculairement l'un à l'autre. Ce système d'assemblage procure une ligne de contact bien définie sur la face de blindage extérieure de chaque panneau blindé, ce qui est particulièrement avantageux pour la continuité électrique entre panneaux blindés adjacents. Les profilés d'assemblage, de bord ou non, permettent en outre de réaliser des cages de Faraday de dimensions importantes, par exemple avec des panneaux blindés dont la longueur peut atteindre cinq mètres.

On obtient donc dans tous les cas une excellente étanchéité électromagnétique, ce qui permet de réaliser des cages de Faraday très performantes.

L'invention n'est pas limitée aux modes de réalisation qui viennent d'être décrits, mais englobe au contraire toute variante reprenant, avec des moyens équivalents, les caractéristiques essentielles énoncées plus haut.

## Revendications

1. Système d'assemblage de panneaux blindés constituant une cage de Faraday, comportant un profilé contre lequel deux panneaux adjacents sont maintenus en appui, caractérisé par le fait que le profilé (100) a en section, la forme générale d'un oméga, avec une portion centrale (101) et deux ailes latérales (102) définissant deux dièdres (104) servant chacun à recevoir un bord de panneau (204), chacun de ces dièdres de réception définissant un angle (d) notablement inférieur à 90° de façon à obtenir un report de la zone de contact à distance de l'arête (205) du bord de panneau correspondant.

2. Système d'assemblage selon la revendication 1, caractérisé par le fait que la zone de contact est, pour chaque bord de panneau (204), reportée d'une part pour la face concernée (201) au niveau d'une arête d'extrémité (105) de l'aile latérale (102) correspondante, et d'autre part pour la facette de chant concernée (203) au niveau du bord correspondant (106) de la portion centrale (101), sensiblement à mi-épaisseur du panneau (P).

3. Système d'assemblage selon la revendication 1 ou 2, caractérisé par le fait que le profilé (100) admet un plan longitudinal de symétrie (PS), et est agencé pour assembler deux panneaux adjacents (P) qui sont dans le prolongement l'un de l'autre, avec une portion centrale (101) dont les branches latérales (101.2) convergent vers le plan de symétrie (PS), et deux ailes latérales (102) légèrement inclinées vers cette portion centrale en s'éloignant d'un plan tangent commun (PT) perpendiculaire audit plan de symétrie.

4. Système d'assemblage selon la revendication 3, caractérisé par le fait que la portion centrale (101) a un profil en forme de U resserré, dont les angles intérieurs (a1) sont compris entre 75° et 85°, en étant de préférence voisins de 80°.

5. Système d'assemblage selon la revendication 3, caractérisé par le fait que chaque aile latérale (102) forme un angle prédéterminé (b1) avec le plan commun tangent (PT), cet angle étant compris entre 1 ° et 5°, en étant de préférence voisin de 2°.

6. Système d'assemblage selon la revendication 1 ou 2, caractérisé par le fait que le profilé (100.1) admet un plan longitudinal de symétrie (PS), et est agencé pour assembler deux panneaux adjacents (P) qui sont essentiellement perpendiculaires entre eux, avec une portion centrale (101) dont les branches latérales (101.2) s'écartent du plan de symétrie (PS), et deux ailes latérales (102) légèrement inclinées vers cette portion centrale en s'éloignant d'un plan tangent commun (PT) perpendiculaire audit plan de symétrie.

7. Système d'assemblage selon la revendication 6, caractérisé parle fait que la portion centrale (101) a un profil en forme de U divergent, dont les angles intérieurs (a2) sont compris entre 120° et 130°, en étant de préférence voisins de 125°.

8. Système d'assemblage selon la revendication 6, caractérisé par le fait que chaque aile latérale (102) forme un angle prédéterminé (b2) avec le plan tangent commun (PT), cet angle étant compris entre 46° et 50 °, en étant de préférence voisin de 47°.

9. Système d'assemblage selon les revendications 3 et 6, caractérisé par le fait que les profilés (100) contre lesquels s'appuient des panneaux horizontaux constituant le toit de la cage de Faraday, reçoivent à l'intérieur de leur portion centrale (101) et au niveau de leurs extrémités, un insert de jonction (300) permettant l'accrochage d'un profilé de bord (100.1) perpendiculaire à ces profilés (100) agencé pour assembler les panneaux horizontaux à des panneaux verticaux adjacents.

10. Système d'assemblage selon la revendication 9, caractérisé par le fait que l'insert de jonction (300) comporte deux portions (301, 302) rigidement liées entre elles, dont une portion prismatique (301) à section trapézoïdale correspondant à celle de la portion centrale (101) du profilé concerné (100), et une portion (302) en forme de barreau s'étendant transversalement à la portion prismatique (301), ladite portion prismatique présentant en outre un béquet (301.2) s'étendant à distance du barreau (302) pour définir une fente de réception (303) associée à l'aile latérale (102) correspondante du profilé de bord (100.1).
